Europäisches Patentamt

European Patent Office

Office européen des brevets

(11) Veröffentlichungsnummer : **0 160 821**
**B1**

(12) **EUROPÄISCHE PATENTSCHRIFT**

(45) Veröffentlichungstag der Patentschrift :
21.12.88

(21) Anmeldenummer : 85103519.6

(22) Anmeldetag : 25.03.85

(51) Int. Cl.⁴ : **G 01 H   3/12, H 01 L 25/04**

(54) Vorrichtung zur Auslese eines zweidimensionalen Ladungsbildes mittels eines Arrays.

(30) Priorität : 04.04.84 DE 3412665

(43) Veröffentlichungstag der Anmeldung :
13.11.85 Patentblatt 85/46

(45) Bekanntmachung des Hinweises auf die Patenterteilung : 21.12.88 Patentblatt 88/51

(84) Benannte Vertragsstaaten :
AT DE FR GB NL

(56) Entgegenhaltungen :
DE–A– 2 851 250
DE–A– 3 224 026
FR–A– 2 238 240
FR–A– 2 494 910
GB–A– 1 530 783
US–A– 3 979 711
IEEE TRANSACTIONS ON ELECTRONIC DEVICES,
Band ED-26, Nr.12, Dezember 1979, Seiten 1921-1931;
IEEE, New York, US. R.G. SWARTZ et al.: "Integrated
Silicon PVF2 acoustic transducer arrays."
ULTRASONICS SYMPOSIUM PROCEEDINGS; New
Orleans, 26-28 September 1979, Seiten 226-231; IEEE,
New York, US. K.M. LAKIN et al.: "Wavefront reconstruction acoustic imaging using two dimensional
arrays."

(73) Patentinhaber : Siemens Aktiengesellschaft Berlin
und München
Wittelsbacherplatz 2
D-8000 München 2 (DE)

(72) Erfinder : Granz, Bernd, Dr.
Leonhard 6
D-8501 Oberasbach (DE)
Erfinder : Oppelt, Ralph, Dipl.-Ing. (FH)
Sudetenlandstrasse 6
D-8602 Memmelsdorf (DE)
Erfinder : Sachs, Bertram
Dorfstrasse 30
D-8520 Erlangen (DE)

## Beschreibung

Die Erfindung bezieht sich auf eine Vorrichtung zur Auslese eines zweidimensionalen Ladungsbildes mittels eines Arrays, das eine Empfänger-Matrix, bestehend aus in Zeilen und Spalten angeordneten Elementarwandlern, und eine Schaltermatrix, bestehend aus einer Trägerplatte und elektronischen Bauteilen in Chipform, die auf der der Empfänger-Matrix abgewandten Flachseite der Trägerplatte angeordnet sind, enthält.

Es ist eine Vorrichtung zur Auslese eines zweidimensionalen Ladungsbildes mit einem Array bekannt, das gestapelte Leiterplatten enthält. Jeweils eine Schmalseite dieser gestapelten Leiterplatten ist mit Elektroden und jeweils eine ihrer Flachseiten ist mit schaltbaren Verstärkern versehen. Diesen Verstärkern ist jeweils ein Ableitwiderstand zugeordnet. Jeweils eine Flachseite der Leiterplatten ist mit einer parallel zu den Schmalseiten verlaufenden Aussparung versehen. Bei dieser Vorrichtung ist den Elektroden der Leiterplatten jeweils ein schaltbarer Verstärker, beispielsweise ein Dual-Gate-MOS-FET, zugeordnet, die in Längsrichtung der Aussparung hintereinander angeordnet sind. Die Verbindungsleiter zwischen den Elektroden und jeweils den entsprechenden schaltbaren Verstärkern sind wenigstens annähernd gleich lang. Die Hauptsteuerleitungen sind auf den den Elektroden gegenüberliegenden Schmalseiten der Leiterplatten in Richtung der Spalten angeordnet, welche jeweils die zur gleichen Spalte gehörenden Steuerleitungen der schaltbaren Verstärker der Leiterplatten elektrisch leitend miteinander verbinden (DE-A1 32 24 026).

Bei dieser Vorrichtung sind die schaltbaren Verstärker in einer Ebene angeordnet, die sich senkrecht zur Bildebene erstreckt. Diese schaltbaren Verstärker sind nach dem Zusammenbau nicht mehr ohne weiteres zugänglich. Beim Ausfall einer Zeile kann man die entsprechende Leiterplatte auswechseln, da die Leiterplatten jeweils eine Zeile der Matrix bilden. Jedoch ist dieser Ausbau mit einer Zerlegung der Vorrichtung verbunden. Ferner muß man eine Leiterplatte austauschen, wenn nur einige Bildpunkte in dieser Zeile ausgefallen sind.

Es ist eine weitere Vorrichtung zur Auslese eines zweidimensionalen Ultraschallbildes mittels eines Arrays bekannt, das eine Ultraschall-Empfänger-Matrix, bestehend aus in Zeilen und Spalten angeordneten Elementarwandlern, und eine Schaltermatrix, bestehend aus einer Trägerplatte und einigen elektronischen Bauteilen in Chipform, die auf den Elementarwandlern abgewandten Flachseite angeordnet sind, enthält. Als Trägerplatte ist ein ätzbares Glas vorgesehen. Jeweils fünf double-diffused metal-oxide-semiconductors DMOS sind zu einem Chip zusammengefaßt und sind auf dem Glassubstrat gebondet. Verbindungsleiter verbinden jeweils die Elementarwandler mit den entsprechenden Chip. Diese Vorrichtung hat eine Ultraschall-Empfänger-Matrix, die 10 x 10 Elementarwandler enthält (M. G. Maginnes, J. D. Plummer, W. L. Beaver, J. D. Meindl ; Medical Physics, Vol. 3, No. 5, Sept./Oct. 1976, Seiten 312 bis 318).

Bei dieser Vorrichtung sind die Verbindungsleiter unterschiedlich lang. Da die Kapazität kleiner Elementarwandler jeweils sehr gering ist, müssen die Verbindungsleiter zwischen den Elementarwandlern und den zugeordneten DMOS jeweils kurz sein, um Verluste zu vermindern. Ferner wirken bei dieser Vorrichtung die DMOS nur als Schalter und nicht als Verstärker. Außerdem erhält man durch unterschiedlich lange Verbindungsleitungen keine homogene Signalverstärkung.

Der Erfindung liegt nun die Aufgabe zugrunde, diese bekannten Vorrichtungen zu verbessern, insbesondere soll der Aufbau so vereinfacht werden, daß man bei Ausfall von einzelnen Bildpunkten durch Auswechseln einzelner Verstärkerchips diesen Fehler beheben kann, ohne dabei die Vorrichtung zu zerlegen. Außerdem soll erreicht werden, daß alle Verbindungsleiter von den Elementarwandlern zu den Eingängen der jeweils zugehörigen Verstärkerchips wenigstens annähernd gleich lang sind.

Diese Aufgabe wird erfindungsgemäß gelöst mit den kennzeichnenden Merkmalen des Anspruchs 1. Den Elementarwandlern ist jeweils ein Verstärkerchip zugeordnet, die in Zeilen und Spalten auf einer Flachseite einer Schaltermatrix angeordnet sind, die von der Empfänger-Matrix abgewandt ist. Auf der der Empfänger-Matrix zugewandten Flachseite der Schaltermatrix sind Elektroden angeordnet, die beispielsjeweils mit Hilfe einer Bohrung mit jeweils einer Kontaktierungslippe der anderen Flachseite der Schaltermatrix verbunden sind. Die Signale der Elementarwandler gelangen durch eine galvanische oder kapazitive Kopplung auf die Elektroden der Schaltermatrix. Die Kontaktierungslippen sind jeweils mit einem Eingang des entsprechenden Verstärkerchips verbunden. Als Verstärker ist beispielsweise ein Dual-Gate-MOS-FET vorgesehen. Außerdem ist jeweils im Verstärkerchip noch ein Ableitwiderstand integriert. Durch diese Gestaltung der Schaltermatrix erhält man eine besonders einfach aufgebaute Vorrichtung zur Auslese eines zweidimensionalen Ladungsbildes. Da die Empfänger-Matrix und die Schaltermatrix mechanisch trennbar sind, kann die Empfänger-Matrix und die Schaltermatrix wechselseitig ausgetauscht werden. Die auf der der Empfänger-Matrix abgewandten Flachseite angeordneten Verstärkerchips sind bei der zusammengebauten Vorrichtung immer noch leicht zugänglich. Beim Ausfall einzelner Bildpunkte können somit die entsprechenden Verstärkerchips schnell und leicht ausgetauscht werden, ohne dabei die Vorrichtung zu zerlegen. Außerdem erreicht man durch die Zuordnung jeweils eines Verstärkerchips zu einem der Elementarwandler, daß alle Verbindungsleiter wenigstens gleich lang und möglichst kurz sind. Dadurch erreicht man, daß die Signalverluste und die Störeinflüsse erheblich verringert sind und man eine homogene Signalverstärkung über die ganze Bildebene erhält.

Eine besonders vorteilhafte weitere Ausgestaltung der Vorrichtung besteht darin, daß die Empfänger-Matrix eine ultraschallempfindliche Schicht, beispielsweise eine Folie aus Polyvinylidenflourid PVDF, und mehrere rechteckförmige Stäbe enthält, die jeweils mit Elektrodenversehen sind. Die Stäbe sind als hartes Backing in Bezug auf die ultraschallempfindliche Schicht vorgesehen. Die Elektroden jedes Stabes sind jeweils auf den Schmalseiten und einer Flachseite angeordnet, wobei die Elektroden der Flachseite vorzugsweise höchstens halb so breit sind wie die Elektroden auf den Schmalseiten. Außerdem sind die Elektroden jeweils angrenzender Seitenflächen um die Außenkante miteinander verbunden. Die rechteckförmigen Stäbe sind ihrer Länge nach nebeneinander angeordnet, wobei ihre Schmalseiten jeweils eine Flachseite der Empfänger-Matrix bilden. Eine dieser Flachseiten ist mit der ultraschallempfindlichen Schicht versehen. Die Flachseite der ultraschallempfindlichen Schicht, die der Flachseite der Empfänger-Matrix abgewandt ist, ist mit einer flächigen Elektrode versehen. Dadurch erhält man eine besonders empfindliche Ultraschall-Empfänger-Matrix und man kann jede beliebige Matrixform, d. h. eine n x n- oder eine n x m-Matrix, zusammenstellen. Außerdem kann man die Länge jedes Stabes beliebig lang wählen, wodurch man die Größe der Bildebene beliebig groß wählen kann.

In einer weiteren Ausführungsform der Vorrichtung enthält die Empfänger-Matrix eine lichtempfindliche Schicht, beispielsweise eine Schicht aus Silizium und mehrere rechteckförmige Stäbe, die jeweils mit Elektroden versehen sind. Außerdem kann man auch quadratische Stäbe verwenden. Durch diese Gestaltung erhält man eine Vorrichtung, mit der man ein zweidimensionales Lichtbild in ein zweidimensionales Ladungsbild umwandelt und parallel ausliest.

Zur weiteren Erläuterung wird auf die Zeichnung Bezug genommen, in der ein Ausführungsbeispiel der Vorrichtung nach der Erfindung schematisch veranschaulicht ist.

Fig. 1 zeigt eine Vorrichtung zur Auslese eines zweidimensionalen Ultraschallbildes gemäß der Erfindung und in

Fig. 2 ist eine Draufsicht auf eine Flachseite der Schaltermatrix dargestellt, die der EmpfangsMatrix abgewandt ist.

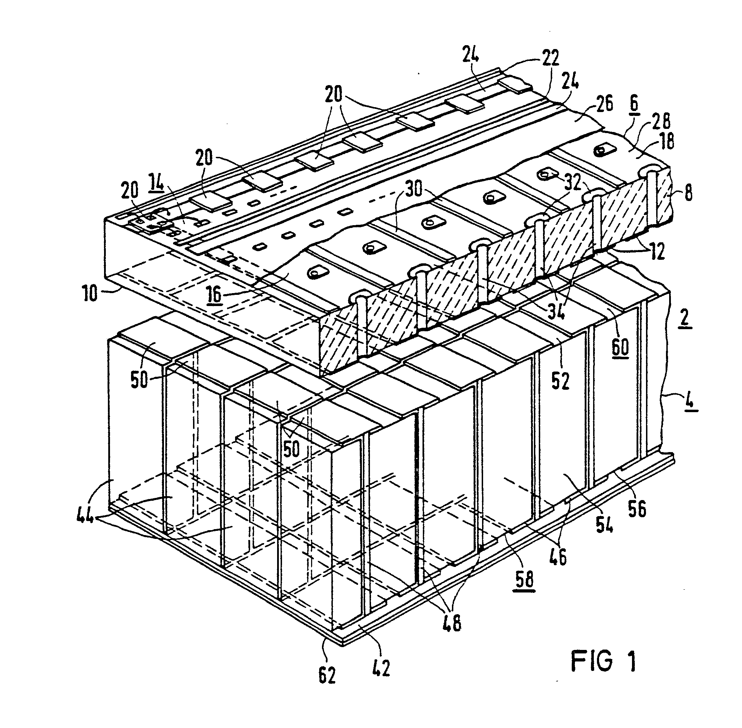

In der Ausführungsform der Figur 1 enthält eine Vorrichtung zur Auslese eines zweidimensionalen Ladungsbildes mittels eines Arrays 2 eine Empfänger-Matrix 4 und eine Schaltermatrix 6. Diese Schaltermatrix 6 besteht aus einer Trägerplatte 8, die parallel zu einer Bildebene angeordnet ist und beispielsweise die Abmessungen eines auszulesenden Bildes hat. Unter Umständen kann die Trägerplatte 8 auch aus mehreren Teilplatten, beispielswelse vier, zusammengesetzt sein. Als Material für die Trägerplatte 8 ist ein ätzbares Glas vorgesehen mit einer Ausdehnung von beispielsweise etwa $20 \times 20 \text{ cm}^2$ und einer Dikke von beispielsweise etwa 1 mm. Die Flachseite 10 der Trägerplatte 8, die der Empfänger-Matrix 4 zugewandt ist, ist mit n x n oder mit n x m Elektroden 12 versehen, die in Zeilen 14 und Spalten 16 angeordnet sind. Diese Matrix, bestehend beispielsweise aus $128 \times 128$, vorzugsweise aus $256 \times 256$ Elektroden 12, hat ein Rastermaß, das kleiner oder gleich der zweifachen reziproken maximalen Ortsfrequenz des darzustellenden Bildes sein soll. Bei einem Ultraschallbild mit einer Ortsfrequenz von 0,5 l/mm ergibt sich für das Rastermaß ein Wert von beispielsweise 1 mm. Auf der der Empfänger-Matrix 4 abgewandten Flachseite 18 der Trägerplatte 8 sind mehrere, beispielsweise $128 \times 128$, vorzugsweise $256 \times 256$ schaltbare verstärker 20 in Chipform vorgesehen. Außerdem ist die Flachseite 18 der Trägerplatte 8 mit Signalausgangsleitungen 22 und Masseleitungen 24 versehen, die auf einer Oxydschicht 26, beispielsweise einer Siliziumoxydschicht, aufgebracht sind. Zwischen dieser Oxydschicht 26 und der ihr zugewandten Oberfläche 28 der Trägerplatte 8 sind Steuerleitungen 30 und Kontaktierungslippen 32 angeordnet. Die Oxydschicht 26 ist im Bereich der Kontaktierungslippen 32 und in Teilbereichen der Steuerleitungen 30 mit Fenstern versehen. Diese Signalausgangsleitungen 22, Steuerleitungen 30, Masseleitungen 24 und Kontaktierungslippen 32 sind in Dünnfilmtechnik auf der Flachseite 18 der Trägerplatte 8 gebracht. Die schaltbaren Verstärker 20 und die Kontaktierungslippen 32 sind jeweils im geometrischen Schatten der Elektroden 12 der Flachseiten 10 angeordnet. Jede Kontaktierungslippe 32 ist jeweils über eine Bohrung 34 mit einer Elektrode 12 elektrisch leitend verbunden. Deshalb ist jeweils die Mantelfläche der Bohrung 34 mit einem leitenden Material versehen. Die Signalausgangsleitungen 22 und die Steuerleitungen 30 sind in Zeilen 14 und Spalten 16 angeordnet, wobei beispielsweise parallel zu den Signalausgangsleitungen 22 die Masseleitungen 24 verlaufen. Die schaltbaren Verstärker 20 sind in Zeilen 14 und Spalten 16 angeordnet, indem sie auf die Masseleitungen 24 angeordnet sind. Als schaltbare Verstärker 20 sind in dieser Ausführungsform Dual-Gate-MOS-FETs vorgesehen. Unter Umständen kann man auch MOS-FETs mit nur einer Gateelektrode oder bipolare Transistoren verwenden. Zu jedem schaltbaren Verstärker 20 ist ein Ableitwiderstand vorgesehen, der jeweils im Verstärkerchip integriert ist.

Die Empfänger-Matrix 4 des Arrays 2 enthält eine ultraschallempfindliche Schicht 42 und mehrere rechteckförmige Stäbe 44, die jeweils mit Elektroden 46, 48, 50 versehen sind. Als ultraschallempfindliche Schicht 42 ist eine Folie aus Polyvinylidenflourid PVDF vorgesehen. Außerdem kann als ultraschallempfindliche Schicht 42 eine piezokeramische Schicht verwendet werden. Unter Umständen kann es nützlich sein, wenn die Empfänger-Matrix 4 eine lichtempfindliche Schicht, beispielsweise Silizium, oder quadratische Stäbe enthält. Die Stäbe 44 sind jeweils als hartes Backing in Bezug auf die ultraschallempfindliche Schicht 42 vorgesehen. Die Elektroden 46, 50 sind jeweils auf den beiden Schmalseiten 56, 52 und die Elektroden 48 sind jeweils auf einer Flachseite 54 jedes Stabes angeordnet. Außerdem sind die Elektroden 46, 48, 50 jeweils angrenzender Seitenflächen um eine Außenkante miteinander verbunden. Die Elektroden 48 der Flachseite 54 jedes Stabes 44 ist vorzugsweise halb so breit wie jeweils die Elektroden 46 und 50 der Schmalseiten 56 und 52 jedes Stabes 44. Ferner sind die Elektroden 46 und 50, die jeweils auf den Schmalseiten 56 und 52 angeordnet sind, mit einem Abstand zur Außenkante der gegenüber der Flachseite 54 angrenzenden Flachseite versehen, damit die Elektroden 46 bzw. 50 angrenzender Stäbe 44 gegeneinander nicht elektrisch leitend verbunden sind. Außerdem haben diese Elektroden 46 und 50 das gleiche Rastermaß, wie die Elektroden 12 der Schaltermatrix 6, nämlich beispielsweise 1 mm bei einer Ortsfrequenz des Ultraschallbildes von beispielsweise 0,5 l/mm. Diese rechteckförmigen Stäbe 44 sind ihrer Länge nach nebeneinander angeordnet, wobei ihre Schmalseiten 56 und 52 jeweils eine Flachseite 58 und 60 der Empfänger-Matrix 4 bilden.

Die Länge jedes Stabes 44 und jeweils die Anzahl der Elektroden 46, 48, 50 wird bestimmt durch die vorbestimmte Matrixform, die beispielsweise n x n oder n x m ist. Beispielsweise bei einer 128 x 128, vorzugsweise 256 x 256 Matrix bilden beispielsweise 128, vorzugsweise 256 rechteckförmige Stäbe 44 jeweils die Flachseiten 58 und 60 der Empfänger-Matrix 4, wobei jeder Stab 44 mit jeweils beispielsweise etwa 128, vorzugsweise 256 Elektroden 46, 48 und 50 versehen sind. Die Flachseite 58 der Empfänger-Matrix 4, die von der Schaltermatrix 6 abgewandt ist, ist mit der ultraschallempfindlichen Schicht 42 versehen. Außerdem ist die Flachseite der ultraschallempfindlichen Schicht 42, die der Bildebene zugewandt ist, mit einer flächigen Elektrode 62 versehen. Die ultraschallempfindliche Schicht 42 ist in Richtung seiner Dicke polarisiert. Die Bereiche, die jeweils zwischen der Matrix der Elektrode 46 und der Elektrode 62 liegen, bilden somit jeweils Elementarwandler.

Die Schaltermatrix 6 wird mit Hilfe eines anisotrop leitenden Kontaktmittels oder eines Materials mit hoher relativer Dielektrizitätskonstante, beispielsweise 5 bis 10, mit der Empfänger-Matrix 4 derart zusammengebracht, daß die Elektroden 12 der Schaltermatrix 6 im geometrischen Schatten der Elementarwandler sich befinden. Als anisotrop leitendes Material ist eine Platte vorgesehen, die senkrecht zur Plattenebene mit einer hohen Leitfähigkeit und parallel zur Plattenebene mit einer niedrigen Leitfähigkeit versehen ist. Somit gelangen die Signale der Elementarwandler galvanisch von den Elektroden 50 auf die Elektroden 12 oder die Signale werden kapazitiv gekoppelt. Außerdem kann man leicht die Schaltermatrix 6 von der Empfänger-Matrix 4 abtrennen und beide Bestandteile können ausgetauscht werden.

Durch diese Gestaltung der Vorrichtung zum Auslesen eines Ladungsbildes kann man die Empfindlichkeit und die Bandbreite vergrößern. Außerdem sind die schaltbaren Verstärker 20 im zusammengebauten Zustand der Vorrichtung noch zugänglich, damit man beim Ausfall einzelner Bildpunkte oder ganzer Zeilen die entsprechenden schaltbaren Verstärker 20 austauschen kann. Weiter hat sich die Herstellung dieser Vorrichtung vereinfacht, indem man alle schaltbaren Verstärker 20 in einem Arbeitsvorgang bondet. Durch die Standartisierung der Elemente der Vorrichtung ist die Herstellung, der Aufbau und die Wartung erheblich vereinfacht worden.

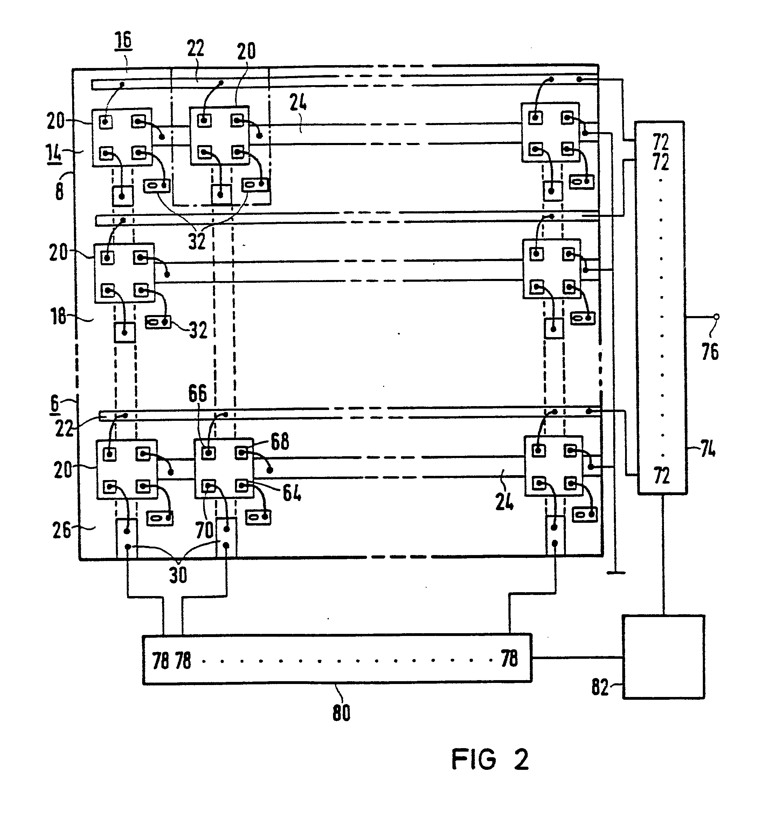

In der Figur 2 ist eine Draufsicht auf die Flachseite 18 der Trägerplatte 8 der Schaltermatrix 6 dargestellt, die der Empfänger-Matrix 4 abgewandt ist. Die schaltbaren Verstärker 20 sind in Zeilen 14 und Spalten 16 angeordnet. Außerdem sind die Signalausgangsleitungen 22 und die Masseleitungen 24 in Zeilen 14 angeordnet. Bei dieser Ausführungsform sind als schaltbare Verstärker 20 Dual-Gate-MOS-FETs mit einem integrierten Ableitwiderstand am ersten Gate 64 vorgesehen, die jeweils auf eine Masseleitung 24 angeordnet sind. In der Oxydschicht 26 sind Fenster vorhanden, damit man Zugriff zu den Steuerleitungen 30, die in Spalten 16 angeordnet sind, und zu den Kontaktierungslippen 32 hat. Das erste Gate 64 jedes Dual-Gate-MOS-FETs ist jeweils mit einer Kontaktierungslippe 32 verbunden. Jeweils die Drainanschlüsse 66 und jeweils die Sourceanschlüsse 68 der Dual-Gate-MOS-FETs einer Zeile 14 sind mit einer Signalausgangsleitung 22 und einer Masseleitung 24 verbunden. Jeweils das zweite Gate 70 der Dual-Gate-MOS-FETs einer Spalte 16 sind mit einer Steuerleitung 30 verbunden. Als Verbindungsleiter sind Bonddrähte vorgesehen. Die Bonddrähte zwischen den Kontaktierungslippen 32 und den entsprechenden ersten Gates 64 sind jeweils annähernd gleich lang. Die beispielsweise 128, vorzugsweise 256 Signalausgangsleitungen 22 werden jeweils mit einem Eingang 72 einer Signalverarbeitungsvorrichtung 74, bestehend beispielsweise aus einem Gleichrichter, einem Integrator, einem Abtasthalteglied und einem 128 : 1 oder 256 : 1 Multiplexer, die in der Zeichnung nicht dargestellt sind, verbunden. Am Ausgang 76 dieser Signalverarbeitungsvorrichtung 74 erhält man seriell das Videosignal. Außerdem werden beispielsweise 128, vorzugsweise 256 Steuerleitungen 30 jeweils mit einem Ausgang 78 eines beispielsweise 128, vorzugsweise 256 bit Schieberegister 80 verbunden. Die Signalverarbeitungsvorrichtung 74 und der Schieberegister 80 werden von einer digitalen Ablaufsteuerung 82 gesteuert.

Durch diese Gestaltung der Schaltermatrix 6 wird erreicht, daß man beispielsweise eine 128 x 128, vorzugsweise 256 x 256 Matrix, die ein Ladungsbild enthält, spaltenweise auslesen kann, d. h. beispielsweise 128, vorzugsweise 256 Signale werden parallel ausgelesen und mit Hilfe der Signalverarbeitungsvorrichtung 74 seriell am Ausgang 76 weitergegeben. Durch dieses parallele Auslesen eines Ladungsbildes wird das Signal/Rauschleistungsverhältnis um den Faktor n, der beispielsweise 128, vorzugsweise 256 ist, verbessert. Außerdem erhält man eine homogene Signalverstärkung, da jedem Elementarwandler ein schaltbarer Verstärker 20 zugeordnet ist und die Verbindungsleiter zwischen jeweils dem ersten Gate 64 der Dual-Gate-MOS-FETs und jeweils einer Kontaktierungslippe 32 annähernd gleich lang sind.

Der Einsatz dieser Vorrichtung zur Auslese eines zweidimensionalen Ladungsbildes in einer Ultraschallkamera erhöht wesentlich die Bildqualität. Außerdem können Ladungsbilder in Real-Time mit hoher Auflösung und hoher Empfindlichkeit dargestellt werden.

**Patentansprüche**

1. Vorrichtung zur Auslese eines zweidimensionalen Ladungsbildes mittels eines Arrays (2), das eine Empfänger-Matrix (4), bestehend aus in Zeilen (14) und Spalten (16) angeordneten Elementarwandlern, und eine Schaltermatrix (6), bestehend aus einer Trägerplatte (8) und elektronischen Bauteilen in Chipform, die auf der der Empfänger-Matrix (4) abgewandten Flachseite (18) der Trägerplatte (8) angeordnet sind, enthält, dadurch gekennzeichnet, daß den Elementarwandlern jeweils ein schaltbarer Verstärker (20) in Chipform zugeordnet ist, die in Zeilen (14) und Spalten (16) angeordnet sind, daß Verbindungsleiter wenigstens annähernd gleicher Länge zwischen Kontaktierungslippen (32) und jeweils den entsprechenden schaltbaren Verstärkern (20) vorgesehen sind.

2. Vorrichtung nach Anspruch 1, dadurch gekennzeichnet, daß die Flachseite (10) der Trägerplatte (8) der Schaltermatrix (6), die der Empfänger-Matrix (4) zugewandt ist, mit Elektroden (12) versehen ist, die in Zeilen (14) und Spalten (16) angeordnet sind.

3. Vorrichtung nach Anspruch 1 und 2, dadurch gekennzeichnet, daß als Verbindung zwischen den Elektroden (12) und den entsprechenden Kontaktierungslippen (32) jeweils eine Bohrung (34) vorgesehen ist, deren Mantelfläche mit einem elektrisch leitenden Material versehen ist.

4. Vorrichtung nach einem der Ansprüche 1 bis 3, dadurch gekennzeichnet, daß als schaltbare Verstärker (20) Dual-Gate-MOS-FETs vorgesehen sind und daß die den schaltbaren Verstärkern (20) zugeordneten Ableitwiderstände jeweils im Verstärkerchip integriert sind.

5. Vorrichtung nach einem der Ansprüche 1 bis 3, dadurch gekennzeichnet, daß als Material der Trägerplatte (8) der Schaltermatrix (6) ein ätzbares Glas vorgesehen ist.

6. Vorrichtung nach Anspruch 1 und 4, dadurch gekennzeichnet, daß mit Hilfe der Verbindungsleiter das erste Gate (64) eines Dual-Gate-MOS-FETs jeweils mit der entsprechenden Kontaktierungslippe (32) verbunden ist und das zweite Gate (70) der Dual-Gate-MOS-FETs jeweils mit einer Steuerleitung (30) verbunden ist und daß der Drainanschluß (66) der Dual-Gate-MOS-FETs jeweils mit einer Signalausgangsleitung (22) verbunden ist.

7. Vorrichtung nach Anspruch 1, dadurch gekennzeichnet, daß Signalausgangsleitungen (22) und Masseleitungen (24) parallel zueinander und zu diesen senkrecht Steuerleitungen (30) verlaufen.

8. Vorrichtung nach Anspruch 1, dadurch gekennzeichnet, daß die Empfänger-Matrix (4) eine ultraschallempfindliche Schicht (42) und mehrere rechteckförmige Stäbe (44) enthält, die jeweils mit Elektroden (46, 48, 50) versehen sind.

9. Vorrichtung nach Anspruch 8, dadurch gekennzeichnet, daß als ultraschallempfindliche Schicht (42) eine Folie aus Polyvinylidenflourid PVDF vorgesehen ist.

10. Vorrichtung nach Anspruch 1, dadurch gekennzeichnet, daß die Empfänger-Matrix (4) eine lichtempfindliche Schicht und mehrere rechteckförmige Stäbe (44) enthält, die jeweils mit Elektroden (46, 48, 50) versehen sind und daß die lichtempfindliche Schicht aus Silizium besteht.

11. Vorrichtung nach Anspruch 10, dadurch gekennzeichnet, daß die Stäbe (44) als hartes Backing in bezug auf die ultraschallempfindliche Schicht (42) vorgesehen sind.

12. Vorrichtung nach Anspruch 8, dadurch gekennzeichnet, daß die Elektroden (50, 46, 48) jeweils auf den beiden Schmalseiten (52, 56) und einer Flachseite (54) jedes Stabes (44) angeordnet sind und daß die Elektroden (46, 48, 50) jeweils angrenzender Seitenflächen um die Außenkante miteinander verbunden sind.

13. Vorrichtung nach einem der Ansprüche 8 bis 12, dadurch gekennzeichnet, daß die Stäbe (44) ihrer Länge nach nebeneinander angeordnet sind, wobei ihre Schmalseiten (52, 56) jeweils eine Flachseite (60, 58) der Empfänger-Matrix (42) bilden.

14. Vorrichtung nach einem der Ansprüche 8 bis 12, dadurch gekennzeichnet, daß die von der Schaltermatrix (6) abgewandte Flachseite (58) der Empfänger-Matrix (4) mit der ultraschallempfindlichen Schicht (42) versehen ist und daß die Flachseite der ultraschallempfindlichen Schicht (42), die von der Flachseite (58) der Empfänger-Matrix (4) abgewandt ist, mit einer flächigen Elektrode (62) versehen ist.

15. Vorrichtung nach einem der Ansprüche 1 bis 14, dadurch gekennzeichnet, daß die Schaltermatrix (6) mit Hilfe eines Materials mit hoher Dielektrizitätskonstante mit der Empfänger-Matrix (4) verbunden ist.

16. Vorrichtung nach einem der Ansprüche 1 bis 14, dadurch gekennzeichnet, daß die Schaltermatrix (6) mit Hilfe eines anisotrop leitenden Kontaktmaterials mit der Empfänger-Matrix (4) verbunden ist.

17. Vorrichtung nach einem der Ansprüche 1 bis 14, dadurch gekennzeichnet, daß das 5 Rastermaß der Elektroden (12) der Schaltermatrix (6) gleich ist dem Rastermaß der Elektroden (50) der Flachseite (60) der Empfänger-Matrix (4), die von der ultraschallempfindlichen Schicht (42) abgewandt ist.

## Claims

1. An apparatus for reading a two-dimensional charge image using an array (2) which has a receiver matrix (4) comprising converter elements arranged in rows (14) and columns (16), and a switching matrix (6) comprising a supporting plate (8) and electronic components in the form of chips which are arranged on the face (18) of the supporting plate (8) facing away from the receiver matrix (4), characterised in that associated with each of the converter elements is a switchable amplifier (20) in the form of a chip, said amplifiers being arranged in rows (14) and columns (16), and in that connecting lines of at least substantially the same length are provided between contact lips (32) and the respective switchable amplifiers (20).

2. An apparatus according to claim 1, characterised in that the face (10) of the supporting plate (8) of the switching matrix (6) which faces the receiver matrix (4) is provided with electrodes (12) which are arranged in rows (14) and columns (16).

3. An apparatus according to claim 1 and claim 2, characterised in that as a connection between the electrodes (12) and the respective contact lips (32) in each case a bore (34) is provided, the wall surface of which is provided with an electrically conductive material.

4. An apparatus according to any one of claims 1 to 3, characterised in that the switchable amplifiers (20) are Dual-Gate-MOS-FETs and that the discharge resistors associated with the switchable amplifiers (20) are integrated in the respective amplifier chips.

5. An apparatus according to any one of claims 1 to 3, characterised in that an etchable glass is used as material for the supporting plate (8) of the switching matrix (6).

6. An apparatus according to claim 1 and claim 4, characterised in that by means of the connecting line the first gate (64) of a dual-gate-MOS-FET is connected to the respective contact lip (32) and the second gate (70) of the dual-gate-MOS-FET is connected to a control line (30) and that the drain terminal (66) of the dual-gate-MOS-FET is connected to a signal output line (22).

7. An apparatus according to claim 1, characterised in that signal output lines (22) and earth lines (24) run parallel to one another and control lines (30) run at right angles thereto.

8. An apparatus according to claim 1, characterised in that the receiver matrix (4) comprises a layer (42) sensitive to ultrasound and a plurality of rectangular bars (44) which are each provided with electrodes (46, 48, 50).

9. An apparatus according to claim 8, characterised in that a foil of polyvinylidene fluoride PVDF is used as the layer (42) sensitive to ultrasound.

10. An apparatus according to claim 1, characterised in that the receiver matrix (4) comprises a light-sensitive layer and a plurality of rectangular bars (44) which are each provided with electrodes (46, 48, 50) and that the light-sensitive layer consists of silicon.

11. An apparatus according to claim 10, characterised in that the bars (44) are provided as hard backing in relation to the layer (42) sensitive to ultrasound.

12. An apparatus according to claim 8, characterised in that the electrodes (50, 46, 48) are respectively arranged on the two narrow sides (52, 56) and on a face (54) of each bar (44) and that the electrodes (46, 48, 50) are connected to one another by bordering side faces around the outer edge.

13. An apparatus according to any one of claims 8 to 12, characterised in that the bars (44) are arranged alongside one another with their respective narrow sides (52, 56) forming a face (60, 58) of the receiver matrix (42).

14. An apparatus according to any one of claims 8 to 12, characterised in that the face (58) of the receiver matrix (4) facing away from the switching matrix (6) is provided with the layer (42) sensitive to ultrasound and that the face of the layer (42) sensitive to ultrasound facing away from the face (58) of the receiver matrix (4) is provided with a laminar electrode (62).

15. An apparatus according to any one of claims 1 to 14, characterised in that the switching matrix (6) is connected to the receiver matrix (4) by means of a material with a high dielectric constant.

16. An apparatus according to any one of claims 1 to 14, characterised in that the switching matrix (6) is connected to the receiver matrix (4) by means of an isotropically conducting contact material.

17. An apparatus according to any one of claims 1 to 14, characterised in that the grid spacing of the electrodes (12) of the switching matrix (6) is the same as the grid spacing of the electrodes (50) of the face (60) of the receiver matrix (4) which faces away from the layer (42) sensitive to ultrasound.

## Revendications

1. Dispositif pour la lecture d'une image de charges bidimensionnelle au moyen d'un système (2) comprenant une matrice de récepteurs (4), constituée de convertisseurs élémentaires disposés en rangées (14) et colonnes (16), ainsi qu'une matrice de commutateurs (6), constituée d'une plaque-support (8) et de composants électroniques sous forme de puces ou pastilles qui sont disposées sur le côté plat (18) de la plaque-support (8) se trouvant à l'opposé de la matrice de récepteurs (4), caractérisé en ce qu'un amplificateur commutable (20) en forme de pastille est associé à chaque convertisseur élémentaire, avec disposition des amplificateurs (20) en rangées (14) et colonnes (16), et que des conducteurs

**0 160 821**

d'interconnexion ayant au moins approximativement la même longueur sont prévus entre des lèvres de mise en contact (32) et les amplificateurs commutables (20) correspondants.

2. Dispositif selon la revendication 1, caractérisé en ce que la plaque-support (8) de la matrice de commutateurs (6) est pourvue, sur son côté plat (10) dirigé vers la matrice de récepteurs (4), d'électrodes disposées en rangées (14) et colonnes (16).

3. Dispositif selon les revendications 1 et 2, caractérisé par la prévision d'un perçage (34) dont la paroi est recouverte d'un matériau électriquement conducteur pour la liaison entre les électrodes (12) et les lèvres (32) correspondantes.

4. Dispositif selon une des revendications 1 à 3, caractérisé en ce que les transistors à effet de champ MOS à double grille sont prévus en tant qu'amplificateurs commutables (20) et que les résistances de fuite coordonnées à ces amplificateurs (20) sont intégrées chacune dans la pastille-amplificateur.

5. Dispositif selon une des revendications 1 à 3, caractérisé en ce que la plaque-support (8) de la matrice de commutateurs (6) est formée avec un verre capable d'être gravé.

6. Dispositif selon les revendications 1 et 4, caractérisé en ce que les conducteurs d'interconnexion servent à relier la première grille (64) de chaque transistor MOS à double grille à une lèvre (32) correspondante et à relier la seconde grille (70) de ce transistor à une ligne de commande (30) et que sa connexion de drain (66) est reliée à une ligne de sortie des signaux (22). ·

7. Dispositif selon la revendication 1, caractérisé en ce que des lignes de sortie des signaux (22) et des lignes de matrice (24) s'étendent parallèlement entre elles et que des lignes de commande (30) s'étendent perpendiculairement à elles.

8. Dispositif selon la revendication 1, caractérisé en ce que la matrice de récepteurs (4) contient une couche (42) sensible aux ultrasons et des barreaux (44) à section droite rectangulaire et qui sont chacun pourvus d'électrodes (46, 48, 50).

9. Dispositif selon la revendication 8, caractérisé en ce qu'une feuille de fluorure de polyvinylidène (PVDF) est prévue en tant que couche (42) sensible aux ultrasons.

10. Dispositif selon la revendication 1, caractérisé en ce que la matrice de récepteurs (4) contient une couche photosensible et des barreaux (44) à section droite rectangulaire et pourvus chacun d'électrodes (46, 48, 50) et que la couche photosensible est en silicium.

11. Dispositif selon la revendication 10, caractérisé en ce que les barreaux (44) sont prévus en tant que support dorsal dur pour la couche (42) sensible aux ultrasons. ·

12. Dispositif selon la revendication 8, caractérisé en ce que les électrodes (50, 46, 48) sont disposées sur les deux petits côtés (52, 56) et sur un côté plat (54) de chaque barreau (44) et que les électrodes (46, 48, 50) des faces latérales adjacentes sont reliées entre elles autour de l'arête extérieure.

13. Dispositif selon une des revendications 8 à 12, caractérisé en ce que les barreaux (44) sont juxtaposés suivant leur longueur, de manière que leurs petits côtés (52, 56) forment respectivement les côtés plats (60, 58) de la matrice de récepteurs (4).

14. Dispositif selon une des revendications 8 à 12, caractérisé en ce que la couche sensible aux ultrasons (42) est disposée sur le côté plat (58) de la matrice de récepteurs (4) se trouvant à l'opposé de la matrice de commutateurs (6) et que le côté plat de cette couche (42) se trouvant à l'opposé dudit côté plat (58) de la matrice de récepteurs (4) est pourvu d'une électrode (62) surface-étendue.

15. Dispositif selon une des revendications 1 à 14, caractérisé en ce que la matrice de commutateurs (6) est reliée à la matrice de récepteurs (4) à l'aide d'un matériau à haute constante diélectrique.

16. Dispositif selon une des revendications 1 à 14, caractérisé en ce que la matrice de commutateurs (6) est reliée à la matrice de récepteurs (4) à l'aide d'un matériau de contact à conduction anisotrope.

17. Dispositif selon une des revendications 1 à 14, caractérisé en ce que le pas de la grille fondamentale des électrodes (12) de la matrice de commutateurs (6) est égal au pas de la grille fondamentale des électrodes (50) situées sur le côté plat (60) de la matrice de récepteurs (4) opposé à la couche (42) sensible aux ultrasons.

FIG 1

FIG 2